(19) **Europäisches Patentamt**

**European Patent Office**

**Office européen des brevets**

(11) Numéro de publication : **0 145 566 B1**

(12) **FASCICULE DE BREVET EUROPÉEN**

(45) Date de publication du fascicule du brevet :
30.09.87

(51) Int. Cl.⁴ : **H 01 L 29/80, H 01 L 29/78**

(21) Numéro de dépôt : **84402364.8**

(22) Date de dépôt : **20.11.84**

(54) Transistor de puissance à effet de champ, et procédé de réalisation de ce transistor.

(30) Priorité : 25.11.83 FR 8318846

(43) Date de publication de la demande :
19.06.85 Bulletin 85/25

(45) Mention de la délivrance du brevet :
30.09.87 Bulletin 87/40

(84) Etats contractants désignés :
DE GB NL

(56) Documents cités :
WO-A-81 /001 74
FR-A- 2 537 781
IEEE ELECTRON DEVICE LETTERS, vol.EDL-5, no.7, juillet 1984, pages 2228-2230, New York, US; Z.RAV-NOY et al.: "Vertical FET's in GaAs"
PATENT ABSTRACTS OF JAPAN, vol.8, nr.81 (E-238)(1519) 13 avril 1984
ELECTRONICS, vol.50, no.17, 18 août 1977, pages 100-106, New York, US; J.B.JENNE: "Grooves add new dimension to V-MOS structure and performance"

(73) Titulaire : **THOMSON-CSF**
**173, Boulevard Haussmann**
**F-75379 Paris Cedex 08 (FR)**

(72) Inventeur : **Perea, Ernesto**
**THOMSON-CSF SCPI 173, bld Haussmann**
**F-75379 Paris Cedex 08 (FR)**

(74) Mandataire : **Taboureau, James et al**
**THOMSON-CSF SCPI 19, avenue de Messine**
**F-75008 Paris (FR)**

### Description

La présente invention concerne un transistor à effet de champ de puissance à canal vertical. Sa structure permet d'obtenir une forte densité de courant, une grande puissance, un faible bruit et une grande vitesse de fonctionnement pour un transistor à effet de champ fonctionnant sous haute tension. Ce transistor comporte deux régions et électrodes de source et drain qui sont portées par deux faces opposées du cristal semiconducteur, et séparées par une couche semiconductrice non dopée et de large bande interdite, le canal vertical étant contrôlé par une grille réalisée sur les flancs d'un sillon en V qui porte la ou les couches actives du transistor.

L'invention s'applique essentiellement aux transistors réalisés en matériaux de la famille III-V, tels que GaAs, $Al_xGa_{1-x}As$..., car des solutions sont connues pour les transistors réalisés en silicium, bien que ceux-ci ont une fréquence supérieure limite plus faible que celle des transistors en matériaux III-V. C'est pourquoi l'invention sera exposée en s'appuyant sur l'exemple, non limitatif, d'un transistor réalisé en GaAs et/ou $Al_xGa_{1-x}As$, que l'on conviendra pour la suite d'écrire AlGaAs pour simplifier.

Actuellement, les transistors à effet de champ à grille Schottky, plus connus sous le nom de MESFET· qui est l'abréviation de métal-semiconducteur-field effect transistor, sont utilisés seulement dans le domaine des faibles puissances. Bien qu'ils possèdent de nombreux avantages théoriques sur les transistors bipolaires homo-jonction, des limitations technologiques dans la fabrication des dispositifs MESFET les empêchent de concurrencer les transistors bipolaires sur silicium dans les applications hyperfréquences de haute puissance. La principale limitation est due au fait que les MESFET sont des dispositifs horizontaux, de telle sorte que leur densité de courant est beaucoup moins grande que celle des bipolaires, lesquels utilisent un courant vertical. Pour obtenir un courant total plus élevé dans les MESFET, il faut augmenter la section transversale du canal.

C'est ce qui est réalisé dans les structures verticales dans lesquelles un substrat nécessairement bon conducteur supporte au moins une couche généralement épitaxiée et bonne conductrice : la surface libre du substrat porte une métallisation d'électrode d'accès, la source par exemple, et la surface libre de la couche porte une métallisation d'une autre électrode d'accès, le drain dans ce cas. Le contrôle du passage du courant, de la source vers le drain, par la grille peut se faire de différentes façons. Dans le document WO-A-8 100 174, la solution proposée consiste à développer, dans une couche de grille placée entre les couches de source et la couche de drain, deux zones déplétées qui s'étendent latéralement, sous le drain, jusqu'à s'interpénétrer. Ces deux zones déplétées sont créées par deux métallisations de grille, déposées de part et d'autre de la couche de drain, gravée en mésa. Un perfectionnement consiste à intercaler des îlots à haute impédance sous les mésas de drain, entre la couche de grille et le substrat·: ainsi, le contrôle du courant source-drain est renforcé, puisque non seulement les zones déplétées se développent horizontalement mais encore le courant se déplace horizontalement dans la couche de grille.

Ce transistor connu peut être réalisé par dépôt épitaxial des diverses couches en utilisant le système GaAs/AlGaAs.

Mais par ailleurs, remplacer un transistor à effet de champ au silicium par un transistor à effet de champ à l'arséniure de gallium par exemple n'a d'intérêt que si ce dernier monte plus haut en fréquence, ou a d'autres caractéristiques améliorées par rapport au transistor sur silicium. Or, il est connu que la fréquence maximale des transistors à effet de champ horizontaux est limitée, en partie, par la précision des opérations de masquage qui détermine la longueur de la grille et les gardes entre source et grille et entre drain et grille. Cette limitation, qui est liée aux opérations de lithographie, a été contournée en réalisant des transistors à effet de champ à structure verticale dans lesquels la longueur de grille est définie par l'épaisseur d'une couche épitaxiée, que l'on sait réaliser bien plus faible que par n'importe quelle méthode de microlithographie. Les plus connus de ces transistors à structure verticale sont les V-MOS, qui sont décrits dans Electronics, 18 août 1977, pages 100 à 106. Une telle structure a été prise en considération dans la première partie de la revendication 1. Dans de tels transistors à effet de champ, la région de source et la région de drain sont donc séparées par une épaisseur de couche qui est la couche active, conductrice par nature mais qui peut être rendue bloquante par l'action du champ électrique de la grille. De tels transistors à effet de champ à structure verticale existent dans le domaine des signaux ou des très faibles puissances, mais bien que la densité de courant puisse être plus élevée puisque le courant passe perpendiculairement à une couche, et non plus selon la faible épaisseur de cette couche, il est difficile de disposer plusieurs transistors de signaux pour en faire un transistor de puissance, à cause des interconnexions de grille prises sur les côtés de la couche active.

Le transistor à effet de champ selon l'invention apporte une solution à ces difficultés par sa structure originale.

Il a une structure verticale, ce qui permet :

d'augmenter la densité de courant en augmentant la section utile du canal,

de disposer une métallisation, celle de drain par exemple, sur une face du cristal, du côté du substrat, et deux métallisations, de source et de grille, sur l'autre face du cristal. Il est plus facile d'interdigiter deux métallisations sur une surface, plutôt que trois métallisations qui nécessitent un système de pont pour s'entrecroiser.

Mais par ailleurs, les régions de source et de drain, qui sont superposées puisque la structure du transistor à effet de champ est verticale, sont séparées entre elles par une couche de matériau de haute résistivité pratiquement isolant. Cette couche de matériau de haute résistivité remplace la couche de grille dans un transistor à effet de champ à structure verticale selon l'art connu. Le passage du courant depuis la région de source vers la région de drain se fait dans la couche active, qui est déposée sur un flanc de la structure c'est-à-dire sur le flanc d'un sillon ouvert dans le cristal. La couche active court-circuite, en quelque sorte, la couche de haute résistivité qui sépare les régions de source et de drain. La couche active, qui est bien entendu recouverte par une métallisation de grille, peut être simple et le transistor est un Mesfet, ou composée de plusieurs couches, par exemple une couche à faible bande interdite et une couche à grande bande interdite. Il est également prévu de disposer, entre la couche active et la métallisation de grille, une couche isolante pour diminuer les fuites : le transistor est alors un Misfet.

De façon plus précise l'invention concerne un transistor de puissance à effet de champ, à structure verticale, comportant d'une part deux métallisations d'électrodes d'accès dites source et drain supportées par les deux faces principales opposées de la pastille du transistor, et d'autre part une métallisation d'électrode de commande dite grille déposée dans un sillon en forme de V creusé dans les régions de source et de drain constituées par au moins deux couches déposées sur le substrat, ce transistor de puissance étant caractérisé en ce que la région de drain est séparée de la région de source par une couche d'un matériau non dopé, de large bande interdite, très résistif, le passage du courant d'une région vers l'autre, interrompu par la couche de matériau résistif étant contrôlé par une dérivation latérale constituée par une couche active, déposée sur les flancs du sillon, creusé dans la structure verticale du transistor à une profondeur suffisante pour interrompre la couche de matériau résistif, la couche active supportant la métallisation d'électrode de grille.

L'invention sera mieux comprise par la description qui suit d'un exemple de transistor de puissance à effet de champ, ainsi que la description du procédé de réalisation de ce transistor, lesquelles s'appuient sur les figures suivantes qui représentent :

figure 1   vue de trois quart dans l'espace d'un transistor à effet de champ classique, de type Mesfet, de faible puissance,

figure 2   vue en plan des métallisations d'électrodes d'un transistor à effet de champ de puissance selon l'art connu,

figure 3   coupe d'un transistor à effet de champ de puissance selon l'invention,

figure 4   vue de trois quart dans l'espace, en arraché, d'un transistor à effet de champ de puissance, selon l'invention,

figures 5 et 6   étapes de réalisation d'un transistor à effet de champ de puissance selon l'invention,

figure 7   variantes de la région de grille.

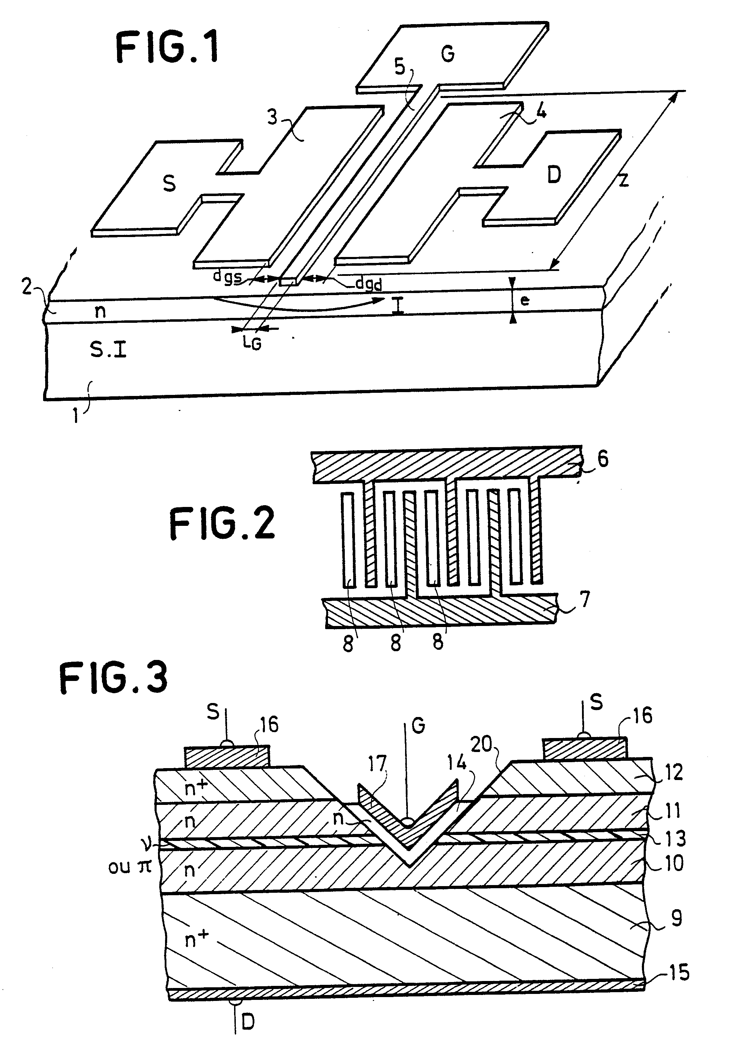

La figure 1 représente une vue de trois quart dans l'espace d'un transistor à effet de champ classique, à grille Schottky, et de faible puissance, ou de signal. Cette figure n'a d'autre objectif que de rappeler les difficultés inhérentes au passage d'un transistor à effet de champ de signal à un transistor à effet de champ de puissance.

Un transistor à effet de champ à grille Schottky comporte au moins un substrat 1, en matériau intrinsèque ou semi-isolant, qui supporte une couche active 2, en matériau de type n par exemple parce qu'il est plus rapide qu'un matériau de type p. A la surface de la couche active 2, sont disposées une électrode de source 3, une électrode de drain 4, parallèles entre elles, et une électrode de grille 5 située entre les électrodes de source et de drain. Chacune de ces électrodes est dotée de moyens pour être raccordée à un potentiel électrique, et ce peut être des plages sur lesquelles sont soudés les fils électriques. Le passage du courant 1 se fait dans la couche active 2, entre la source et le drain, et la densité de courant est fonction de l'épaisseur « e » de cette couche active. Les caractéristiques du transistor sont fixées par la longueur $L_g$ de la grille, mesurée selon le sens du courant entre source et drain, ainsi que par les distances de garde $d_{gs}$ qui sépare la métallisation de grille de la métallisation de source, et $d_{gd}$ qui sépare la métallisation de grille de la métallisation de drain. Pour qu'un transistor fonctionne en haute fréquence, il est nécessaire que la longueur de grille $L_g$ soit courte de façon à avoir un temps de transit court, et que les gardes $d_{gs}$ et $d_{gd}$ soient également courtes.

Pour obtenir davantage de puissance, à haute fréquence pour un tel transistor, il faut augmenter la surface transversale du canal, c'est-à-dire augmenter la largeur Z de l'électrode de grille et par conséquent également du transistor. Pour augmenter le courant total, et augmenter la densité de courant, il faut diminuer la longueur de la grille $L_g$ et des gardes grille-source $d_{gs}$ et grille-drain $d_{gd}$.

Mais l'augmentation de largeur Z de la région de grille est limitée par son effet sur la résistance de la grille, et la diminution de la longueur $L_g$ et des gardes est limitée par les moyens de lithographie utilisés.

Une solution connue pour augmenter la puissance d'un transistor à effet de champ consiste à placer plusieurs transistors en parallèle, dans une configuration interdigitée. La figure 2 représente la vue en plan des métallisations d'électrodes d'un transistor de puissance à effet de champ interdigité.

Du fait que dans le plan de la surface d'une pastille de transistor il y a par définition deux dimensions, il n'est pas possible de réaliser les métallisations de trois électrodes interdigitées sans éviter des croisements. Soit 6 une première métallisation, de source par exemple, et 7 une seconde métallisation, de drain par exemple. Il est possible de leur donner une configuration en peigne et d'interdigiter deux peignes de source et de drain. Mais si dans ce cas les métallisations 8 sont les métallisations de grille, il n'est pas possible de les relier à une source de tension ou de polarisation autrement que par des ponts par fils, qui passent par dessus l'une ou l'autre des métallisations 6 et 7, ou par des trous réalisés à travers le substrat. Ces techniques sont bien connues et il n'est pas utile de les décrire avec précision mais néanmoins il est nécessaire de rappeler que les ponts dans l'air réalisés par fils métalliques présentent une self et une capacité lorsqu'ils croisent les électrodes 6 ou 7, et que par ailleurs les trous réalisés dans un substrat rendent le transistor fragile, parce qu'il faut amincir le substrat pour accéder à une métallisation d'électrodes par en-dessous.

Le transistor à effet de champ de puissance selon l'invention permet d'éviter les inconvénients qui ont été cités à l'occasion des deux premières figures. Il est représenté, vue en coupe, en figure 3, et les problèmes d'interconnexion entre les trois métallisations de source, de grille et de drain sont résolus par la structure verticale du transistor qui comporte deux métallisations sur une face de la pastille, et une métallisation sur l'autre face de la pastille. La longueur de grille, dans le sens du courant, entre source et drain n'est plus limitée par la technique de microlithographie, et des densités de courant beaucoup plus élevées sont possibles.

Le transistor à effet de champ de puissance selon l'invention comporte une première région d'accès, qui est la région constitué par deux couches conductrices 9 et 10. Il comporte une seconde région d'accès qui est alors dans le cas d'exemple choisi la région de source, constitué par deux couches conductrices 11 et 12. Ces deux régions sont superposées, et séparées entre elles par une couche de matériau non dopé, de large bande interdite et très résistif 13. Le passage du courant de la région de source vers la région de drain se fait dans l'épaisseur d'une couche active 14 qui est déposée sur le flanc d'un sillon, creusé dans le corps du transistor : la couche active 14 constitue donc un pont court-circuitant la couche très résistive 13, et reliant entre elles les régions de source et de drain. Bien entendu, le transistor comporte également une électrode de drain 15 portée par la couche 9 de la région de drain, une électrode 16 portée par la couche 12 de la région de source et une électrode de grille 17 portée par la couche active 14.

Dans la structure du transistor selon l'invention la couche 9 est en fait le substrat, en matériau tel que GaAs, dopé $n^+$ à $10^{18}$ $cm^{-3}$, ce qui en fait la couche d'accès à l'électrode du drain. De plus, il est nécessaire pour prendre un bon contact ohmique sur une couche de GaAs que celui-ci soit dopé $n^+$.

La couche 10 constitue la couche de drain, et elle est réalisée en matériau tel que GaAs dopé n, à hauteur de $10^{17}$ $cm^{-3}$, sur une épaisseur de 1 $\mu$m.

La couche de haute résistivité 13 est une couche de AlGaAs, de 0,2 $\mu$m d'épaisseur, comportant $10^{14}$ impuretés par $cm^3$ : c'est une couche non dopée.

La couche 11 est la couche de source, elle est réalisée en GaAs de type n dopé à $10^{17}$ $cm^{-3}$, et a une épaisseur de 0,5 $\mu$m. La couche 12 est la couche d'accès à l'électrode de source, elle est réalisée en GaAs de type $n^+$ dopé à $10^{18}$ $cm^{-3}$ sur une épaisseur de 1 $\mu$m.

Enfin, la couche active 14 est réalisée par épitaxie par jets moléculaires, sur 0,06 $\mu$m d'épaisseur ; elle est en GaAs de type n ou composé de plusieurs couches comme cela sera expliqué par la suite.

Dans le transistor de puissance selon l'invention, le courant se déplace donc verticalement depuis l'électrode de source vers l'électrode de drain, perpendiculairement aux couches et non plus dans le sens de l'épaisseur des couches comme c'est le cas pour les transistors de signaux horizontaux : le courant passe de la région de source à la région de drain à travers l'épaisseur de grille qui est longue de 0,2 $\mu$m ou même moins selon les moyens d'épitaxie dont on dispose. Le transistor a une structure symétrique par rapport au plan de la couche résistive 13, les couches 10 et 11 étant respectivement les couches de drain et de source, tandis que les couches 9 et 12 ont — outre la fonction de substrat pour la couche 9 — la fonction de couches d'accrochages pour les contacts ohmiques des métallisations.

Le transistor selon l'invention permet d'avoir des longueurs de grille aussi courtes que l'épaisseur que l'on sait réaliser pour une couche résistive 13, et des largeurs de grille, c'est-à-dire la dimension Z sur la figure 1, plus courtes puisque l'on sait augmenter la densité du courant. En outre, la surface totale du transistor sur une plaquette de matériau ou sur une pastille de circuit intégré est plus petite, du fait que le transistor est vertical et que le contact de drain s'effectue sur la face arrière du substrat, sans interconnexion sur la face supérieure du transistor et sans perçage du substrat.

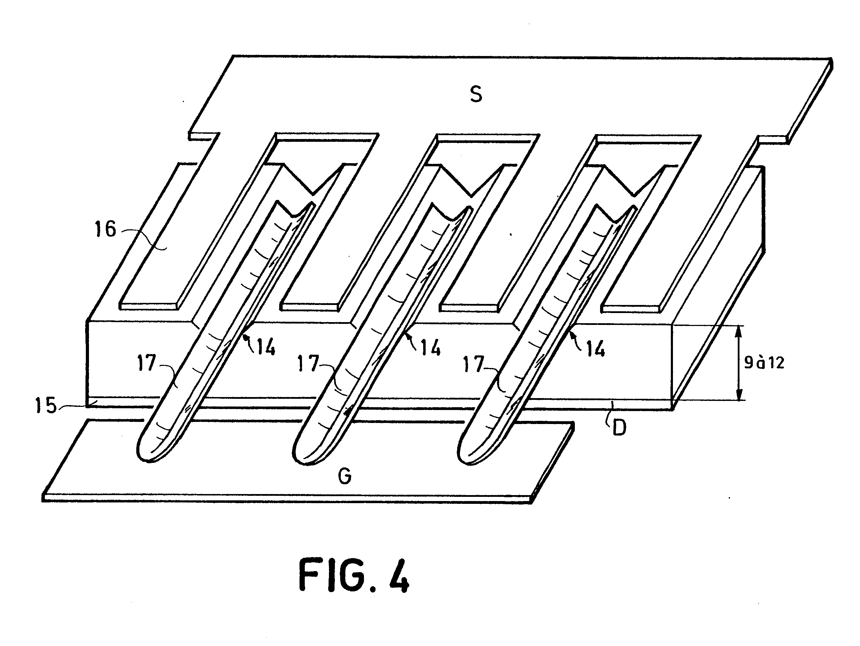

La figure 4 représente une vue de trois quart dans l'espace en arraché d'un transistor de puissance selon l'invention. Pour mieux montrer la structure du transistor, cette figure est partiellement arrachée et ne conserve du corps du transistor, c'est-à-dire de la pastille de matériau semiconducteur, que la partie qui se trouve entre les électrodes de source et de grille.

Le corps semiconducteur du transistor c'est-à-dire l'ensemble du substrat 9 et des couches 10 à 12 est creusé par des sillons parallèles entre eux dans lesquels sont déposées les couches actives 14, qui sont ici cachées par la perspective. Les électrodes de source et de grille sont interdigitées sur une première face du corps du transistor, tandis que l'électrode de drain est portée par l'autre face du corps du transistor, c'est-à-dire par le substrat. Bien entendu, la structure peut être inversée et l'électrode de source portée par le substrat tandis que l'électrode de drain est portée par la face supérieure de la pastille du transistor. Il n'y a donc aucun croisement entre des métallisations d'électrodes ni dans l'air, ni supporté par une couche isolante, et il n'y a pas non plus de perçage du substrat pour atteindre une électrode, par en dessous, à travers un trou.

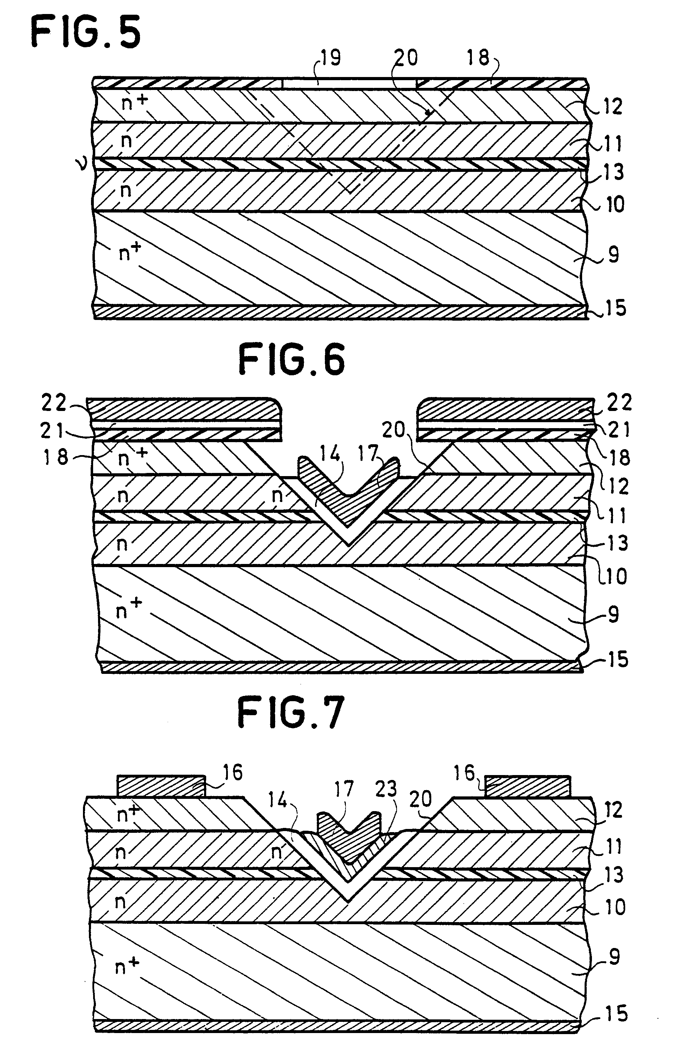

Le procédé de fabrication du transistor selon l'invention est décrit par les figures 5 et 6, qui en représentent les étapes préliminaires complétées par la figure 3 qui représente une coupe du transistor achevée.

Le procédé de fabrication d'un transistor de puissance selon l'invention part d'un substrat 9, en figure 5, de matériau dopé $n^+$, au niveau $n_d = 10^{18}$ cm$^{-3}$, de faible résistivité, orienté $< 100 >$, et déjà muni d'un contact ohmique de face arrière, sous forme d'une métallisation 15. Sur le substrat est épitaxiée par une méthode telle que l'épitaxie par jets moléculaires, une couche 10 de type n, à environ $n_d = 10^{17}$ cm$^{-3}$, sur une épaisseur de 1 $\mu$m. Puis la couche résistive 13 est épitaxiée sur une épaisseur d'environ 0,2 $\mu$m, son degré d'impureté, puisqu'à ce niveau là il n'y a pas de dopage, étant de l'ordre de $n = 10^{14}$ cm$^{-3}$. Une seconde couche 11 de matériau de type n dopée au niveau de $10^{17}$ cm$^{-3}$, sur une épaisseur de 0,5 $\mu$m, est déposée sur la couche intrinsèque, et enfin la couche de prise de contact 12 dopée de type $n^+$ au niveau $10^{18}$ cm$^{-3}$ sur une épaisseur de 1 $\mu$m.

La rondelle recouverte de couches épitaxiées est ensuite recouverte d'un dépôt de silice 18 sur une épaisseur de 300 nm (3 000 angströms) environ. Dans cette couche de silice est ouverte, par les méthodes connues de masquage, une fenêtre 19 qui permettra de creuser le sillon 20, qui est représenté en pointillés sur la figure 5. L'ouverture de la fenêtre 19 qui correspond, au niveau de la surface du futur transistor, à un rectangle qui entoure la grille, doit être alignée avec la direction $< 01\bar{1} >$ du cristal.

Une attaque chimique anisotropique est réalisée avec une solution d'eau oxygénée et d'acide chlorhydrique : cette attaque produit une gravure en forme de V, et il y a sous la couche de silice 18 une légère sous-gravure, parce que la solution d'eau oxygénée et d'acide chlorhydrique attaque également les couches de matériaux selon un plan horizontal. Ainsi, pour une ouverture de 2 $\mu$m de la fenêtre 19, le V qui sera creusé dans les couches épitaxiées a, au niveau de la couche de silice 18, une ouverture de 3,5 $\mu$m.

La suite des opérations de réalisation du transistor selon l'invention est représentée sur la figure 6.

Le sillon 20 étant creusé dans les couches épitaxiées, une première épitaxie, sur 60 nm (600 angströms) d'épaisseur, par jets moléculaires, permet de déposer la couche active 14. En même temps que la couche active 14 est déposée dans le fond du sillon, avec auto-masquage par les bords de la couche de silice 18 qui débordent sur le sillon puisqu'il y a eu sous-gravure, une couche 21 du même matériau est déposée sur la surface supérieure de la rondelle.

La couche active est en matériau de type GaAs, elle est de type n dopée entre $5.10^{16}$ et $5.10^{18}$ cm$^{-3}$. Elle peut être également composite comme cela sera expliqué ultérieurement.

Après l'épitaxie de la ou des couches actives, le contact Schottky de grille 17 est déposé par évaporation de titane-platine-or, sur 300 nm (3 000 angströms) d'épaisseur. De même que pour la couche active, la couche de silice qui déborde sur le sillon par suite de la sous-gravure sert de masque d'auto-alignement, et, de même, une couche 22 de métal Schottky est déposée sur la surface de la rondelle du transistor.

Les opérations suivantes consistent à supprimer les trois couches de silice 18, de matériau semiconducteur 21 et d'alliage Schottky 22 qui se trouvent sur la face supérieure du transistor. Pour cela, la couche de silice est attaquée chimiquement par une solution diluée d'acide fluorhydrique dans l'eau, qui est sélective pour la silice. Ce procédé est connu sous le nom de lift-off.

Le procédé de lift-off, en attaquant sélectivement la couche 18 de SiO2, à partir de la sous-gravure dans le sillon 20, permet aux couches supérieures, c'est-à-dire à la couche de matériau semiconducteur 21 et à la couche de métal Schottky 22, de se détacher automatiquement de la rondelle portant le transistor. Il ne reste donc après cette opération, en fait de métallisations d'électrodes, que la métallisation de drain 15 portée par la face postérieure du substrat et la métallisation Schottky 17 de grille portée par la couche active 14 dans le sillon 20. L'opération suivante consiste alors à réaliser les métallisations ohmiques 16 de source qui sont représentées sur la figure 3, la couche 12 étant dopée de type $n^+$ pour assurer un bon contact ohmique sur la source, de la même façon que le substrat a été choisi dopé $n^+$ pour assurer un bon contact ohmique sur le drain 15.

Dans cette réalisation, les couches 9 et 12 ont en outre une fonction de couche d'accès présentant une faible résistance entre la métallisation de drain 15 et la couche de drain 10 d'une part et entre la métallisation de source 16 et la couche de source 11 d'autre part. Le niveau de dopage $10^{17}$ pour les deux couches de drain 10 et de source 11 est destiné à diminuer la capacité parasite entre la couche et la grille et à augmenter les tensions de claquage.

Par ailleurs, la grille 17 ne recouvrant que partiellement le drain 15, et avec toute l'épaisseur du transistor entre les deux métallisations, la capacité parasite drain-grille est assez faible, ce qui conduit aux plus grandes vitesses de fonctionnement.

Les hautes vitesses de fonctionnement sont elles-mêmes favorisées par le fait que la longueur de grille, c'est-à-dire $L_g$ sur la figure 1, est déterminée par l'épaisseur de la couche résistive 13, cette épaisseur étant de l'ordre de quelques centaines voir quelques dizaines d'angströms par jets moléculaires.

La figure 7 représente la région de grille du transistor selon l'invention dans deux variantes possibles. Deux variantes peuvent être représentées par la même figure car elles se différencient entre elles par la nature des couches. Une première variante à l'invention consiste à interposer entre l'unique couche active 14 et la métallisation 17 une couche d'isolant 23, de façon à diminuer les fuites par la grille. L'isolant peut être de la silice ou un nitrure de silicium par exemple. Le transistor est dans ce cas un Misfet.

Une seconde variante au transistor selon l'invention consiste à déposer une couche active elle-même composée d'une première couche 14 d'un matériau à faible bande interdite, non dopé, et d'une seconde couche 23 d'un matériau de large bande interdite, dopé n. La seconde couche supporte la métallisation de grille 17. Les couches 14 et 23 forment une hétérojonction, et le transistor fonctionne selon un régime de gaz d'électrons bidimensionnel.

La première couche (14) est une couche de GaAs par exemple, de type n, sur une épaisseur de 100 nm (1 000 Å). Si la première couche (14) est en GaAs, la seconde couche (23) est en $Al_xGa_{1-x}As$, dopée $n^+ \simeq 10^{18}$ $cm^{-3}$, sur 80 nm (800 Å) d'épaisseur.

Bien entendu, des transistors réalisés avec d'autres couples de matériaux de la famille III-V appartiennent au domaine de l'invention.

Le transistor de puissance à effet de champ selon l'invention a de nombreuses applications industrielles : dans le domaine des hyperfréquences de puissance, les étages de sorties des émetteurs à plus de 10 GHz (bande X) rayonnant plusieurs watts sont possibles. De même, le canal court de ce transistor lui confère un faible bruit, ce qui est favorable à l'amplification de puissance en large bande.

Enfin, la grande impédance d'entrée et la grande vitesse de fonctionnement du transistor de l'invention en font un excellent dispositif de commutation de puissance, pour les diodes laser par exemple.

**Revendications**

1. Transistor de puissance à effet de champ, à structure verticale, comportant d'une part deux métallisations d'électrodes d'accès (15, 16) dites source et drain supportées par les deux faces principales opposées de la pastille du transistor, et d'autre part une métallisation d'électrode de commande (17) dite grille déposée dans un sillon (20) en forme de V creusé dans les régions de source et de drain constituées par au moins deux couches (10, 11) déposées sur le substrat (9), ce transistor de puissance étant caractérisé en ce que la région de drain (10) est séparée de la région de source (11) par une couche (13) d'un matériau non dopé, de large bande interdite, très résistif, le passage du courant d'une région vers l'autre, interrompu par la couche de matériau résistif (13) étant contrôlé par une dérivation latérale constituée par une couche active (14 ; 14, 23), déposée sur les flancs du sillon (20), creusé dans la structure verticale du transistor à une profondeur suffisante pour interrompre la couche de matériau résistif (13), la couche active (14 ; 14, 23) supportant la métallisation (17) d'électrode de grille.

2. Transistor de puissance à effet de champ selon la revendication 1, caractérisé en ce que :

la région de drain est constituée par une couche d'accès (9), de matériau de faible bande interdite, dopé $n^+ \simeq 10^{18}$ $cm^{-3}$, et par une couche de drain (10) de matériau de faible bande interdite, dopé $n \simeq 10^{17}$ $cm^{-3}$,

la couche très résistive (13) est en matériau de large bande interdite, intrinsèque non dopé ($n \simeq 10^{14}$ $cm^{-3}$),

la région de source est constituée par une couche d'accès (12), de matériau de faible bande interdite, dopé $n^+ \simeq 10^{18}$ $cm^{-3}$, et par une couche de source (11) de matériau de faible bande interdite, dopé $n \simeq 10^{17}$ $cm^{-3}$,

la disposition des couches (9, 10, 12, 11) du transistor étant symétrique par rapport à la couche très résistive (13), les deux couches d'accès (9, 12), peu résistives, supportant les métallisations de source et de drain (16, 15), l'une au moins des deux couches d'accès constituant le substrat (9) du transistor.

3. Transistor de puissance à effet de champ selon la revendication 1, caractérisé en ce que la couche active (14) est formée par une couche de matériau de faible bande interdite, dopé $n \simeq 5 \cdot 10^{16}$ à $10^{17}$ $cm^{-3}$ (MESFET).

4. Transistor de puissance à effet de champ selon la revendication 1, caractérisé en ce que la couche active (14, 23) comporte une couche (14) de matériau de faible bande interdite, dopé $n \simeq 5 \cdot 10^{16}$ à $10^{17}$ $cm^{-3}$, et une couche (23) d'un matériau isolant, intercalée entre la couche (14) de matériau de faible bande interdite et la métallisation de grille (17) (MISFET).

5. Transistor à effet de champ selon la revendication 1, caractérisé en ce que la couche active (14, 23) comporte une hétéro-jonction formée entre une couche (14) de matériau de faible bande interdite et une couche (23) de matériau de large bande interdite, cette dernière supportant la métallisation de grille (17).

6. Transistor de puissance à effet de champ selon l'une quelconque des revendications 1 à 5, caractérisé en ce qu'il est réalisé en matériaux de la famille III-V, alliages binaires tels que GaAs ou ternaires tels que $Al_xGa_{1-x}As$.

7. Procédé de réalisation d'un transistor de puissance à effet de champ, de structure verticale, selon la revendication 1, comportant la suite des opérations suivantes :

a. sur un substrat (9) en matériau $n^+$ de faible bande interdite, orienté < 100 >, dépôt par épitaxie d'une première couche (10), de type n, d'une seconde couche (13) très résistive, d'une troisième couche (11), de type n, et d'une quatrième couche (12), de type $n^+$, la couche résistive (13) étant en matériau de large bande interdite, et les autres couches (10, 11, 12) en matériau de faible bande interdite,

b. dépôt d'une couche isolante (18) en surface des couches épitaxiées, masquage et ouverture d'une fenêtre (19) dans la couche isolante (18) par attaque chimique sélective, la fenêtre étant orientée < 011 >,

c. creusement d'un sillon (20) par attaque chimique non sélective (HC + HO$_2$), selon l'orientation < 111 > des couches épitaxiées (10 à 13), le sillon (20) affectant partiellement la première couche épitaxiée (10),

d. dépôt dans le sillon, par épitaxie et autoalignement, d'au moins une couche (14) de matériau semiconducteur, formant couche active de grille, et d'une métallisation (17) d'électrode de grille,

e. élimination par attaque chimique de la couche isolante (18),

f. dépôt des métallisations (15, 16) de contacts ohmiques de source et drain.

## Claims

1. Field effect power transistor having a vertical structure and comprising, on the one hand, two access electrode metallizations (15, 16) referred to as source and drain and carried by the two opposed main faces of the transistor chip, and, on the other hand, a control electrode metallization (17) referred to as gate and deposited in a groove (20) having the shape of a V and worked into the source and drain regions formed by at least two layers (10, 11) deposited on the substrate (9), this power transistor being characterized in that the drain region (10) is separated from the source region (11) by a layer (13) of an undoped material having a wide forbidden band and being highly resistive, the current flow from one region to another, separated by the layer of resistive material (13) being controlled by a lateral derivation constituted by an active layer (14 ; 14, 23) deposited on the sides of the grooves (20) which is worked into the vertical structure of the transistor to a depth sufficient to interrupt the layer of resistive material (13), the active layer (14 ; 14, 23) carrying the gate electrode metallization (17).

2. Field effect power transistor according to claim 1, characterized in that :

the drain region is constituted by an access layer (9) of a material having a small forbidden band and n$^+$-doped at $\simeq$ 10$^{18}$ cm$^{-3}$, and by a drain layer (10) of a material having a small forbidden band and n-doped at $\simeq$ 10$^{17}$ cm$^{-3}$,

the highly resistive layer (13) is of a material having a wide forbidden band and which is intrinsic and undoped (n $\simeq$ 10$^{14}$ cm$^{-3}$),

the source region is constituted by an access layer (12) of a material having a small forbidden band and n$^+$-doped at $\simeq$ 10$^{18}$ cm$^{-3}$, and by a source layer (11) of a material having a small forbidden band and n-doped at $\simeq$ 10$^{17}$ cm$^{-3}$,

the arrangement of the layers (9, 10, 12, 11) of the transistor being symmetric with respect to the highly resistive layer (13), the two access layers (9, 12) of low resistivity carrying the source and drain metallizations (16, 15) at least of the two access layers constituting the substrate (9) of the transistor.

3. Field effect power transistor according to claim 1, characterized in that the active layer (14) is formed by a layer of a material having a small forbidden band and n-doped at $\simeq$ 5 · 10$^{16}$ to 10$^{17}$ cm$^{-3}$ (MESFET).

4. Field effect power transistor according to claim 1, characterized in that the active layer (14, 23) comprises a layer (14) of a material having a small forbidden band and n-doped at $\simeq$ 5 · 10$^{16}$ to 10$^{17}$ cm$^{-3}$, and a layer (23) of an insulating material interposed between the layer (14) of a material having a small forbidden band and the gate metallization (17) (MISFET).

5. Field effect transistor according to claim 1, characterized in that the active layer (14, 23) comprises a heterojunction formed between a layer (14) of a material having a small forbidden band and a layer (23) of a material having a wide forbidden band, the latter carrying the gate metallization (17).

6. Field effect power transistor according to any of claims 1 to 5, characterized in that it is embodied of a material of the group III-V, binary alloys such as GaAs or ternary alloys such as Al$_x$Ga$_{1-x}$As.

7. Method of producing a field effect power transistor having a vertical structure, according to claim 1, comprising the sequence of the following operations :

a. on a substrate (9) of n$^+$-material having a small forbidden band and the orientation < 100 >, a first layer (10) of n type is epitaxially deposited, a second, highly resistive layer (13) is deposited, a third layer (11) of n type is deposited and a fourth layer (12) of n$^+$ type is deposited, the resistive layer (13) being of a material having a wide forbidden band and the other layers (10, 11, 12) being of a material having a small forbidden band,

b. an insulating layer (18) is deposited on the surface of the epitaxially formed layers, a masking is performed and a window (19) is opened in the insulating layer (18) by selective chemical attack, the window being oriented < 011 >,

c. a groove (20) is formed by non-selective chemical attack (HC + HO$_2$), along the orientation < 111 > of the epitaxially formed layers (10 to 13), the groove (20) partially extending into the first epitaxial layer (10),

d. at least one layer (14) of semiconductor material forming an active gate layer is epitaxially deposited in the groove in self-aligning manner, and a gate electrode metallization (17) is deposited in the groove,

e. the insulating layer (18) is eliminated by chemical attack,

f. ohmic contacting source and drain metallizations (15, 16) are deposited.

**Patentansprüche**

1. Feldeffekt-Leistungstransistor mit vertikaler Struktur, einerseits versehen mit zwei Zugangselektroden-Metallisierungen (15, 16), die als Source und Drain bezeichnet werden und von den beiden einander gegenüberliegenden Hauptflächen des Transistorplättchens getragen werden, und andererseits mit einer Steuerelektroden-Metallisierung (17), die als Gate bezeichnet wird und in einer V-förmigen Rille (20) abgelagert ist, welche in die Source- und Drain-Gebiete eingesenkt ist, die durch wenigstens zwei auf dem Substrat (9) aufgebrachte Schichten (10, 11) gebildet sind, wobei dieser Leistungstransistor dadurch gekennzeichnet ist, daß das Drain-Gebiet (10) von dem Source-Gebiet (11) durch eine Schicht (13) aus einem hochresistiven undotierten Material von breitem verbotenen Energieband getrennt ist, wobei der Stromdurchgang von einem Gebiet zum anderen, welche durch die Schicht aus resistivem Material (13) unterbrochen sind, durch eine seitliche Abzweigung gesteuert wird, die durch eine aktive Schicht (14 ; 14, 23) gebildet ist, welche auf den Flanken der Rille (20) abgelagert ist, die in die vertikale Transistorstruktur bis zu einer Tiefe eingesenkt ist, die ausreicht, um die Schicht aus resistivem Material (13) zu unterbrechen, wobei die aktive Schicht (14 ; 14, 23) die Gateelektroden-Metallisierung (17) trägt.

2. Feldeffekt-Leistungstransistor nach Anspruch 1, dadurch gekennzeichnet, daß :

das Drain-Gebiet gebildet ist durch eine Zugangsschicht (9) aus einem Material mit schmalem verbotenen Energieband und einer $n^+$-Dotierung von $\cong 10^{18}$ cm$^{-3}$ sowie durch eine Drain-Schicht (10) aus einem Material mit schmalem verbotenen Energieband und der n-Dotierung von $\cong 10^{17}$ cm$^{-3}$,

die hochresistive Schicht (13) aus einem eigenleitenden undotierten (n $\cong 10^{14}$ cm$^{-3}$) Material mit breitem verbotenen Energieband besteht,

das Source-Gebiet durch eine Zugangsschicht (12) aus einem Material mit schmalem verbotenen Energieband und der $n^+$-Dotierung von $\cong 10^{18}$ cm$^{-3}$ sowie durch eine Source-Schicht (11) aus einem Material mit schmalem verbotenen Energieband und der n-Dotierung von $\cong 10^{17}$ cm$^{-3}$ gebildet ist,

die Anordnung der Schichten (9, 10, 12, 11) des Transistors symmetrisch in bezug auf die hochresistive Schicht (13) ist, wobei die zwei wenig resistiven Zugangsschichten (9, 12) die Source- und Drain-Metallisierungen (16, 15) tragen, wobei wenigstens eine der zwei Zugangsschichten das Substrat (9) des Transistors bildet.

3. Feldeffek-Leistungstransistor nach Anspruch 1, dadurch gekennzeichnet, daß die aktive Schicht (14) durch eine Schicht eines Materials mit schmalem verbotenen Energieband und einer n-Dotierung von $\cong 5 \cdot 10^{16}$ bis $10^{17}$ cm$^{-3}$ gebildet ist (MESFET).

4. Feldeffekt-Leistungstransistor nach Anspruch 1, dadurch gekennzeichnet, daß die aktive Schicht (14, 23) eine Schicht (14) aus einem Material mit schmalem verbotenen Energieband und einer n-Dotierung von $\cong 5 \cdot 10^{16}$ bis $10^{17}$ cm$^{-3}$ und eine Schicht (23) aus einem Isoliermaterial umfaßt, welche zwischen die Schicht (14) aus einem Material mit schmalem verbotenen Energieband und die Gatemetallisierung (17) eingefügt ist (MISFET).

5. Feldeffekt-Transistor nach Anspruch 1, dadurch gekennzeichnet, daß die aktive Schicht (14, 23) einen Heteroübergang aufweist, der zwischen einer Schicht (14) aus einem Material mit schmalem verbotenen Energieband und einer Schicht (23) aus einem Material mit breitem verbotenen Energieband gebildet ist, wobei letztere die Gatemetallisierung (17) trägt.

6. Feldeffekt-Leistungstransistor nach einem der Ansprüche 1 bis 5, dadurch gekennzeichnet, daß er aus einem Material der Gruppe III-V gebildet ist, aus binären Legierungen wie GaAs oder ternären Legierungen wie Al$_x$Ga$_{1-x}$As.

7. Verfahren zur Herstellung eines Feldeffekt-Leistungstransistors mit vertikaler Struktur nach Anspruch 1, mit der nachstehenden Folge von Arbeitsschritten :

a. Auf einem Substrat (9) aus $n^+$-Material mit schmalem verbotenen Energieband und der Orientierung < 100 > werden epitaktisch eine erste Schicht (10) vom n-Typ, eine zweite, hochresistive Schicht (13), eine dritte Schicht (11) vom n-Typ und eine vierte Schicht (12) vom $n^+$-Typ aufgebracht, wobei die resistive Schicht (13) aus einem Material mit breitem verbotenen Energieband besteht und die anderen Schichten (10, 11, 12) aus einem Material mit schmalem verbotenen Energieband bestehen,

b. eine Isolierschicht (18) wird auf der Oberfläche der epitaktisch aufgebrachten Schichten aufgebracht, eine Maskierung wird vorgenommen, und ein Fenster (19) wird in der Isolierschicht (18) durch selektives chemisches Ätzen geöffnet, wobei dieses Fenster gemäß < 01$\bar{1}$ > orientiert ist,

c. eine Rille (20) wird durch nichtselektives chemisches Ätzen (HC + HO$_2$) mit der Orientierung < 111 > in die epitaktischen Schichten (10 bis 13) eingesenkt, wobei diese Rille (20) teilweise bis in die erste epitaktische Schicht (10) vordringt,

d. in der Rille wird epitaktisch und selbstausrichtend wenigstens eine Schicht (14) aus Halbleitermaterial, welche eine aktive Gateschicht bildet, aufgebracht und wird eine Gateelektroden-Metallisierung (17) aufgebracht,

e. Eliminieren der Isolierschicht (18) durch chemisches Ätzen,

f. Aufbringen von Metallisierungen (15, 16) als ohmsche Source- und Drain-Kontakte.

# FIG.1

# FIG.2

# FIG.3

FIG. 4

# FIG.5

# FIG.6

# FIG.7